# EUROPEAN PATENT APPLICATION

(11) **EP 2 587 487 A1**
(43) Date of publication of application: **01.05.2013**
(21) Application number: 12189745.8
(22) Date of filing: 24.10.2012
(51) Int. Cl.: G11C 29/00, G06F 12/02

(54) **File system and control method thereof**

(30) Priority: 24.10.2011 KR 20110108825
(71) Applicant: Samsung Electronics Co., Ltd, Gyeonggi-do 443-742 (KR)
(72) Inventor: Cho, Dong Seok, Seoul (KR)
(74) Representative: Grünecker, Kinkeldey, Stockmair & Schwanhäusser

(57) **Abstract**

A file system including a first memory unit which is non-volatile and has a plurality of blocks, a control unit configured to select one of the plurality of blocks of the first memory unit (301), determine whether the selected block is a valid block, control a data write with respect to the selected block if the selected block is a valid block, divide the plurality of blocks into valid blocks and bad blocks by checking the plurality of blocks of the first memory unit (302), generate an address table by mapping the valid blocks and the bad blocks to addresses (303) and control a loading of the address table generated, and a second memory unit which is volatile and stores the address table for the plurality of blocks of the first memory unit. An address table of a flash memory, which is a non-volatile memory, is stored in another memory (304).

## Description

### BACKGROUND

### 1. Field

Embodiments of the present disclosure relate to a file system to manage a bad block of a memory, and a control method thereof.

### 2. Description of the Related Art

A file system is an apparatus designed to read and write data of a memory in file units.

Such a file system manages physical location of a file stored in various types of storage devices, such as a hard disk, CD-ROM, DVD, Blu-ray, flash memory, etc.

Since the flash memory is a memory configured in a block unit, a complicated driving algorithm is required, and a write speed and a read speed are slow. In addition, the flash memory does not support the writing and reading in page units having a small scale. Accordingly, a more efficient file management method is needed for the flash memory.

The flash memory, which is a non-volatile memory device, performs recording and erasing in an electrical manner.

Cells of the flash memory form a plurality of blocks, and each block serves as a minimum unit to erase data stored in the cell.

The flash memory, during a programming operation or an erasing operation, is implemented using a tunneling effect, which involves passing through a high energy barrier, and a hot carrier effect, which causes a hot carrier with a high kinetic energy to pass through an insulating material. Such a programming operation and erasing operation may become a factor of limiting the number of recording data to the cell while causing the cell to erroneously operate during the data write operation. In addition, defective flash memory cells may be manufactured due to various limitations of a flash memory manufacturing process that requires a high integrating degree.

That is, the flash memory, during the manufacturing process or the operating process, brings into a defect on a memory cell.

A cell determined to have at least one of such a defect is referred to as a bad block.

The existence of a bad block complicates the use of a flash memory, developing a demand for a management on the bad block.

In order for the flash memory to manage the bad block, replacement information between a bad block and a valid block is generated as an address table during the read/write of the flash memory, and the replacement information is stored in a reserved area of the flash memory. Thereafter, an access is made to data exiting on the physical block address by use of the address table stored in the flash memory. However, such an access method has a slow speed.

In addition, a bad block replacement is performed in consideration of read/write areas, and an address table is generated and stored also for a run time bad.

In order to prepare for a power failure that may occur while an address table is being stored, the address table is stored together with a copied address table.

Accordingly, functionalities of the flash memory are complicated, and a spatial efficiency of the memory is degraded.

### SUMMARY

Therefore, it is an aspect of the present disclosure to provide a file system capable of checking for a bad block and a valid block of one memory unit, generating a table about the checked bad block and the checked valid block, and loading the table to another memory unit, and a control method thereof.

It is another aspect of the present disclosure to provide a file system capable of generating an address table only for a predetermined partition on a memory that is mainly used to perform a read operation, and a control method thereof.

It is another aspect of the present disclosure to provide a file system capable of mapping a valid block starting from the lowest rank address and mapping a bad block starting from the highest rank address.

Additional aspects of the disclosure will be set forth in part in the description which follows and, in part, will be obvious from the description, or may be learned by practice of the disclosure.

In accordance with one aspect of the present disclosure, a file system includes a first memory unit, a control unit, and a second memory unit. The first memory unit may be non-volatile and has a plurality of blocks. The control unit may be configured to select one of the plurality of blocks of the first memory unit, determine whether the selected block is a valid block, control a data write with respect to the selected block if the selected block is a valid block, divide the plurality of blocks into valid blocks and bad blocks by checking the plurality of blocks of the first memory unit, generate an address table by mapping the valid blocks and the bad blocks to addresses and control a loading of the address table generated. The second memory unit may be volatile and store the address table for the plurality of blocks of the first memory unit.

The control unit may perform a checking on a predetermined partition of the first memory unit.

The predetermined partition may be an area having a read data.

The file system further includes an interface unit configured to receive a data used to perform a write on the first memory and indicate a data that corresponds to a command of the control unit.

The control unit may generate the address table by sequentially mapping the valid blocks to addresses starting from a lowest rank address among the addresses, and sequentially mapping the bad blocks to addresses starting from a highest rank address among the addresses.

If the selected block is a bad block, the control unit may be select another block and determine whether the other block is a valid block to perform a data write.

The control unit may perform a read operation only on the valid block based on the address table stored in the second memory unit.

The control unit may regenerate the address table when the first memory unit is booted.

The first memory unit may include a readable memory.

In accordance with another aspect of the present disclosure, a method of controlling a file system is as follows. A plurality of blocks of a first memory unit, which is non volatile, is checked to divide the plurality of blocks into valid blocks and bad blocks. An address table is generated by mapping the divided valid blocks and bad blocks to addresses. The generated address table is loaded to a second memory unit that is volatile. The generated address table is stored in the second memory unit. A read operation is performed only on the valid block based on the address table that is stored in the second memory unit, if a read command for the first memory unit is input.

The generating of the address table includes sequentially mapping logical block addresses to physical block addresses of the valid blocks, starting from a lowest rank logical block address among the logical block addresses; and sequentially mapping logical block addresses to physical block addresses of the bad blocks, starting from a highest rank logical block address among the logical block addresses, thereby generating the address table.

The method further includes selecting one of the plurality of blocks of the first memory unit if a write command is input through an interface unit; determining whether the selected block is a valid block; and performing a data write operation on the selected block if the selected block is a valid block.

The method further includes selecting another block of the plurality of blocks if the selected block is a bad block and determining whether the other block is a valid block; and performing a data write.

The checking of the plurality of blocks of the first memory unit to divide the plurality of blocks into the valid blocks and the bad blocks includes marking a predetermined partition of the first memory unit; and performing a checking on blocks within the predetermined partition to divide the checked blocks into bad blocks and valid blocks.

In accordance with another aspect of the present disclosure, a file system includes a first memory unit and a second memory unit. The first memory unit may be non-volatile and have a plurality of blocks. The second memory unit may be configured to store an address table, in which valid blocks and bad blocks of the plurality of blocks of the first memory unit have addresses mapped thereto.

As described above, an address table of a flash memory, which is a non-volatile memory, is stored in another memory, thereby preventing constraints that are related to storing an address table at a power failure.

In addition, a file access speed of a flash memory, which is a non-volatile memory, is increased.

In addition, a predetermined partition of a flash memory is used as a read-only file system.

In addition, acquiring the entire space for a bad block is not required. While implementing programs, such as a boot loader and a firmware for mass production image, a bad block of a flash memory is skipped by referring to an address table of the flash memory that is stored in another memory.

In addition, while developing an embedded system, an environment of a file system for managing a flash memory is built.

### BRIEF DESCRIPTION OF THE DRAWINGS

These and/or other aspects of the disclosure will become apparent and more readily appreciated from the following description of embodiments, taken in conjunction with the accompanying drawings of which:
FIG. 1 is a block diagram illustrating a file system in accordance with an embodiment of the present disclosure.
FIG. 2 is a flow chart of a write operation of a file system in accordance with an embodiment of the present disclosure.
FIG. 3 is a flow chart of a process of generating an address table of a file system in accordance with an embodiment of the present disclosure.
FIGS. 4A, 4B, 5A and 5B are diagrams illustrating an example of generating an address table of a file system in accordance with an embodiment of the present disclosure.

### DETAILED DESCRIPTION

Reference will now be made in detail to embodiments of the present disclosure, examples of which are illustrated in the accompanying drawings, wherein like reference numerals refer to like elements throughout.

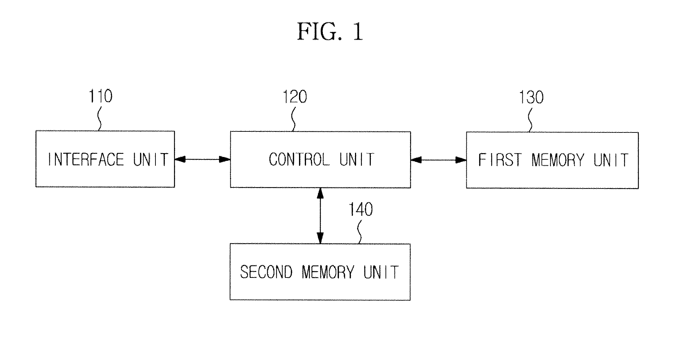

FIG. 1 is a block diagram illustrating a file system in accordance with an embodiment of the present disclosure. The file system includes an interface unit 110, a control unit 120, a first memory unit 130, and a second memory unit 140.

The interface unit 110 receives a write command, a read command, and an erase command of data from a user.

The interface unit 110 outputs data that is read from the first memory unit 130 and the second memory unit 140 according to a command of the control unit 120. Such an interface unit 110 includes an input unit, such as a keyboard, a mouse and a touch screen, and a display unit such as a monitor or a touch screen.

The control unit 120 includes an application processor that serves to control a file system and perform operations.

An application of the control unit 120 generates a command used to access files that are stored in the first memory unit 130.

The control unit 120 performs a mapping on logic block addresses and physical block addresses of the first memory unit 130 to generate an address table, and loads an address table, which is obtained through the mapping and has information about whether each block is bad or valid, to the second memory unit 140.

The control unit 120, if a request for a task on a file is received through an application, reads the address table stored in the second memory unit 140, which is volatile, acquires a logic block address of a file of an area of the first memory unit 130 desired to make an access, replaces the acquired logic block address into a physical block address of the first memory unit 130, and accesses a physical block by conveying the physical block address and an access command. The request for a task includes a read request, a write request and an update request.

That is, the control unit 120 accesses a file stored in the first memory unit 130 by using the address table stored in the second memory unit 140.

In addition, the control unit 120 makes a read request only on a valid block of the first memory unit 130 without making a read request on a bad block.

Hereinafter, a configuration of mapping logical block addresses and physical block addresses in the first memory unit 130 will be described in detail.

The control unit 120 marks a predetermined partition or the whole partition of the plurality of blocks of the first memory unit 130, and checks whether blocks within the marked partition are available for use to divide the blocks into bad blocks and valid blocks.

The control unit 120 allocates logical block addresses to marked partitions, and sequentially maps physical block addresses of the valid blocks and the bad blocks of the first memory unit 130 to the logical block addresses to generate an address table, and controls a loading of the generated address table.

During the mapping of the address, the control unit 120 sequentially maps physical block addresses of the valid blocks to logical block addresses in the order of the lowest rank logical block address the first, and sequentially maps physical block addresses of the bad blocks to logical block addresses in the order of the highest rank logical block address the first. However, the present disclosure is not limited thereto. For example, the control unit may sequentially maps physical block addresses of the valid blocks to logical block addresses in the order of the highest rank logical block address the first, and sequentially maps physical block addresses of the bad blocks to logical block addresses in the order of the lowest rank logical block address the first. Further, mapping valid blocks and bad blocks may be in any order.

The mapping of the physical addresses of the valid blocks and the bad blocks is performed starting from the lowest rank physical block address.

The control unit 120, if a write command is input through the interface unit 110, selects a block of the plurality of blocks of the first memory unit 130, determines whether the selected block is a valid block, and perform a data write on the selected block if the selected block is a valid block.

The control unit 120, if the selected block is a bad block, skips the selected block, selects another block among the plurality of blocks, and determines whether the other block selected is a valid block to perform a data write.

The first memory unit 130, while serving as an auxiliary memory device in which a program of the control unit 120 before execution is stored, stores various data of a file system.

The first memory unit 130 includes a non-volatile memory capable of performing operations such as a read-only operation, a read operation, and a write operation.

The non-volatile memory is a memory in which the recorded information is not changed with an elapse of time erasable, and is not erased without having a power applied. For example, the non-volatile memory includes a Read Only Memory (ROM) for an exclusive use of read, an Erasable Programmable Read Only Memory (EPROM), an Electrically Erasable Programmable Read Only Memory (EEPROM), a flash memory, a Ferro-electric Random Access Memory (FRAM), and a Phase-change Random Access Memory (PRAM).

The embodiment is described in relation to a flash memory as the first memory unit 130.

The flash memory includes a plurality of physical blocks storing data and physical block addresses.

The plurality of physical blocks includes a valid block that is available to perform a read, a write and an edit of data, and a bad block that is unavailable for a read, a write and an edit of data. That is, the data is stored in the valid block.

The first memory unit 130, which is a flash memory, performs an access operation on the physical blocks in response to the physical block address and the access command of the control unit 120. In this case, an access command on a valid block is delivered from the control unit 120, and the first memory unit 130 performs an access to the valid block.

For example, the first memory unit 130 performs a write, a read, or an erase operation on a physical block corresponding to a physical block address that is delivered, in which the write, read or erase operation is performed only on a valid block.

The second memory unit 140, while serving as a main memory device on which a program that is to be executed by the control unit 120 is loaded, loads an application of the control unit 120 thereon and temporarily stores data.

The second memory unit 140 is a volatile memory, which is able to read and write and requires a power to keep information stored. For example, the second memory unit 140 may include a Random-Access Memory (RAM). The RAM may include a Dynamic Random-Access Memory (DRAM) and Static Random-Access Memory (SRAM).

The RAM reads data by using an integrated circuit (IC) into which transistors (TR) are integrated. The RAM reads in a random manner not in a sequential manner, providing a fast read or write speed. In addition, the RAM is provided with a plurality of circuits for a write and a read, thereby able to perform a write and a read.

Therefore, the speed of accessing data of the first memory unit 130 is increased.

The second memory unit 140 stores an address table, in which logical block addresses, which identify a predetermined file, are mapped to physical block addresses which store actual data.

The address table includes information about whether each block is bad or valid.

The address table is used to make an access to a file in the first memory unit 130 according to a command of the control unit 120, and is regenerated and stored when a file system is booted.

In addition, the address table stored in the second memory unit 140 is able to be updated whenever each file in the first memory unit 130 is accessed.

The file system may be embedded in home appliances, such as a washing machine, a refrigerator, an air conditioner, an oven, and the like, however, is not limited thereto.

Since the home appliance uses the data stored in the first memory unit 130 as it is, the first memory unit 130 may use a read-only memory and the control unit 130 generates an address table only for a read area of the first memory unit 130.

In a case that the plurality of blocks of the first memory unit 130 includes a write area, the control unit 120 may apply its own bad block processing method, such as Journalling Flash File System version 2 (JFFS2), Yet Another Flash File System version 2 (YAFFS2), Unsorted Block Image File System (UBIFS), and the like, on the write area.

In addition, by using a flash memory as the first memory, the stability is improved and the manufacturing cost is reduced, and also the file system according to the present disclosure is efficiently applied to an embedded system.

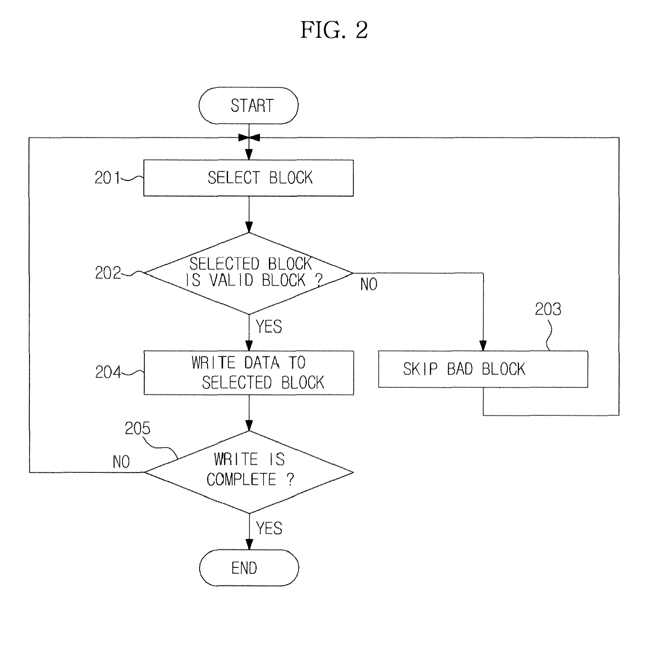

FIG. 2 is a flow chart of a write operation of a file system in accordance with an embodiment of the present disclosure.

A process of performing a data write on the first memory unit 130 for the first time is as follows.

The control unit 120 of the file system selects one of the plurality of blocks of the first memory unit 130 if a write command is input through the interface unit 110 (201).

The control unit 120 determines whether the selected block is a valid block or a bad block (202).

The control unit 120, if determined that the selected block is a bad block, skips the selected block (203), and repeats operations 201 to 203.

If the selected is a valid block, a data write is performed on the selected block (204).

Thereafter, the control unit 120 determines whether the data write is complete (205).

If determined that the data write is not complete, the data write is performed while the plurality of blocks is being divided into valid blocks and bad blocks. If determined that the data write is complete, the data write is finished.

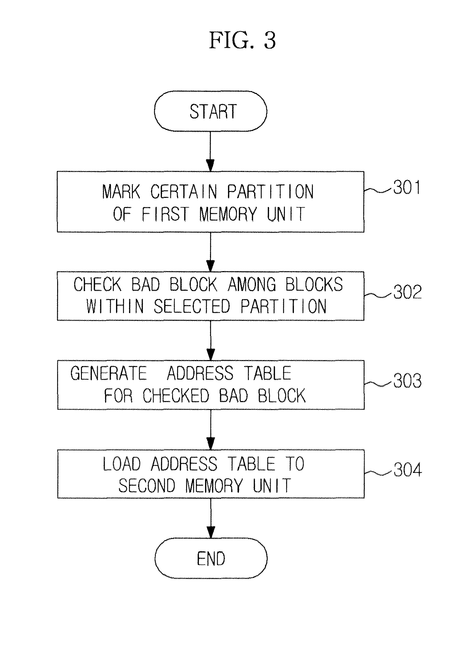

FIG. 3 is a flow chart of a process of generating an address table of a file system in accordance with an embodiment of the present disclosure. The process of generating an address table will be described in conjunction with FIGS. 1, 4, and 5.

The control unit 120 selects and marks a predetermined partition of the plurality of blocks of the first memory unit 130 (301). The predetermined partition represents blocks having data stored thereon, and corresponds to a read area.

In addition, if there is a need to generate an address table for all blocks of the first control unit 130, all of the blocks are selected and marked.

The control unit 120 allocates logical block addresses to blocks within the predetermined marked partition.

Thereafter, the control unit 120 checks bad blocks and valid blocks by verifying the usability of each block (302).

The control unit 120 generates an address table by sequentially maps physical block addresses of the valid blocks and the bad blocks of the first memory unit 130 to the logical block addresses (303), and loads the generated address table to the second memory unit 140 (304).

The second memory unit 140 stores the address table of the first memory unit 130, and makes access to the address table of the first memory unit 130 according to a command of the control unit 120.

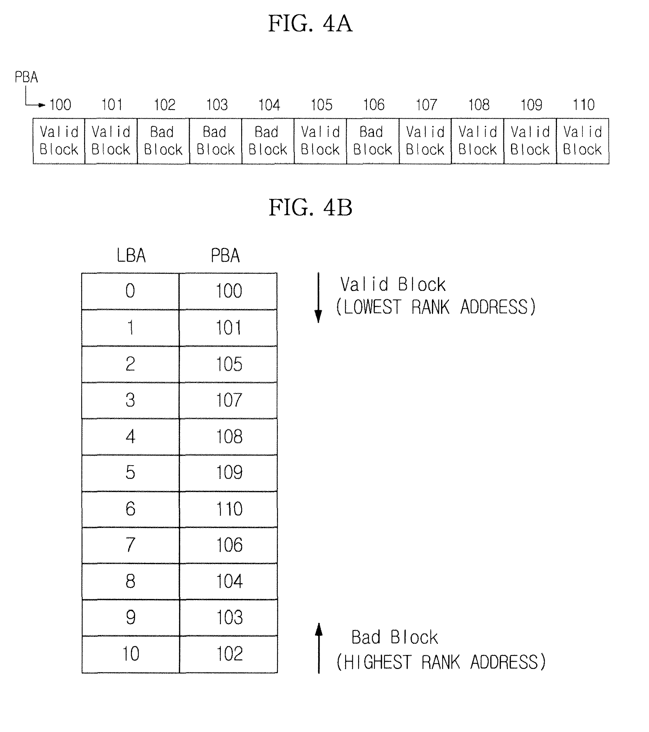

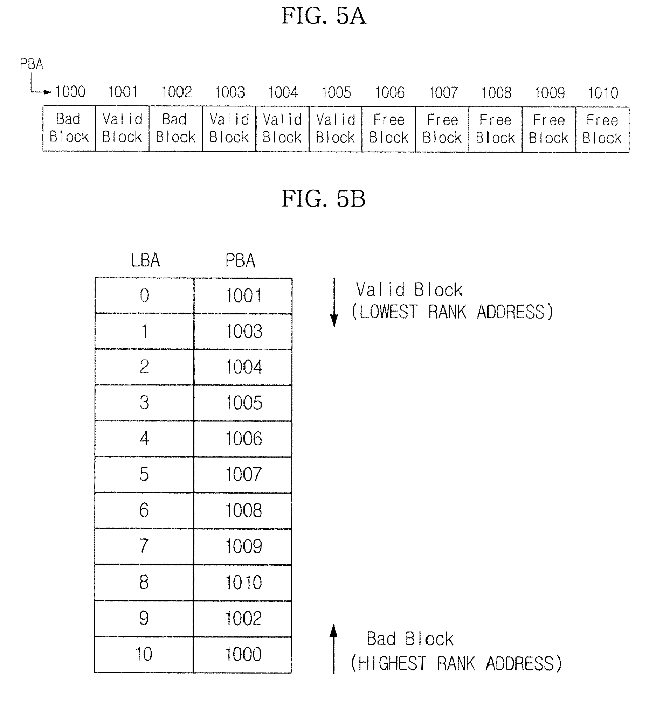

Hereinafter, the address mapping will be described with reference to FIGS. 4 and 5.

The first memory unit 130 has a plurality of blocks, and each block stores a physical block address (PBA).

Referring to FIG. 4A, a first block of the first memory unit 130 is a valid block and has a physical block address of 100, a second block of the first memory unit 130 is a valid block and has a physical block address of 101, a third block, a fourth block, and a fifth block of the first memory unit 130 are bad blocks and have physical block addresses of 102, 103, and 104, respectively, a sixth block of the first memory unit 130 is a valid and has a physical block address of 105, a seventh block of the first memory unit 130 is a bad block and has a physical block address of 106, and an eighth block to an eleventh block of the first memory unit 130 are valid blocks and have physical block addresses of 107,108, 109, and 110, respectively.

The control unit 120 allocates each block a logical block addresses (LBA) of the first memory unit 130 ranging from 0 to 10, and maps the physical block addresses of the first memory unit 130 to the logical block addresses allocated.

In this case, the control unit 120 sequentially maps the logical block addresses to the physical block addresses of the valid blocks, starting from the lowest rank logical block address of 0, and sequentially maps the logical block address to the physical block addresses of the bad blocks, starting from the highest rank logical block address of 10. However, the present disclosure is not limited thereto. For example, the control unit may sequentially maps the logical block addresses to the physical block addresses of the valid blocks, starting from the highest rank logical block address of 10, and sequentially maps the logical block address to the physical block addresses of the bad blocks, starting from the lowest rank logical block address of 0. Further, mapping valid blocks and bad blocks may be in any order.

The mapping of the physical block addresses of the valid blocks and the bad blocks is performed starting from the lowest rank physical address.

Referring to FIG. 4B, the physical block addresses 100, 101, 105, 107, 108, 109, and 110 of the valid blocks are sequentially mapped to the logical block addresses starting from the lowest rank logical block address of 0.

That is, the logical block address of 0 is mapped to the physical block address 100, the logical block address of 1 is mapped to the physical block address 101, the logical block address of 2 is mapped to the physical block address 105, the logical block address of 3 is mapped to the physical block address 107, the logical block address of 4 is mapped to the physical block address 108, the logical block address of 5 is mapped to the physical block address 109, and the logical block address of 6 is mapped to the physical block address 110.

Thereafter, the physical block addresses 102, 103, 104, and 106 of the bad blocks are sequentially mapped to the logical block addresses, starting from the highest rank logical block address of 10.

That is, the logical block address of 10 is mapped to the physical block address 102, the logical block address of 9 is mapped to the physical block address 103, the logical block address of 8 is mapped to the physical block address 104, and the logical block address of 7 is mapped to the physical block address 106.

Hereinafter, referring to FIGS. 5A and 5B, the address mapping is described in relation that a free block which does not store data exists.

The first memory unit 130 has a plurality of blocks, and the plurality of blocks includes a bad block, a valid block and a free block, and each block has a physical block address.

Referring to FIG. 5A, a first block of the first memory unit 130 is a bad block and has a physical block address 1000, a second block of the first memory unit 130 is a valid block and has a physical block address 1001, a third block of the first memory unit 130 is a bad block and has a physical block address 1002, a fourth block, a fifth block and a sixth block of the first memory unit 130 are valid blocks and have physical block addresses 1003, 1004, and 1005, respectively, and a seventh block to an eleventh block of the first memory unit 130 are free blocks and have physical block addresses 1006, 1007, 1008, 1009, and 1010.

The control unit 120 allocates each block of the first memory unit 130 to a logical block address ranging from 0 to 10, and maps the physical block addresses of the first memory unit 130 to the logical block addresses allocated.

The control unit 120 sequentially maps the logical block addresses to the physical block addresses of the valid blocks, starting from the lowest rank logical block address of 0, sequentially maps the logical block addresses to the physical block addresses of the bad blocks, starting from the highest rank logical block address of 10, and maps remaining logical block addresses to the physical block addresses of the free blocks starting from the lowest rank logical block address among the remaining logical block addresses. However, the present disclosure is not limited thereto. For example, The control unit may sequentially maps the logical block addresses to the physical block addresses of the valid blocks, starting from the highest rank logical block address of 10, sequentially maps the logical block addresses to the physical block addresses of the bad blocks, starting from the lowest rank logical block address of 0, and maps remaining logical block addresses to the physical block addresses of the free blocks starting from the lowest or highest rank logical block address among the remaining logical block addresses. Further, mapping valid blocks, bad blocks and free blocks may be in any order.

The mapping of the physical block addresses of the valid blocks, the bad blocks and the free blocks is performed starting from the lowest rank physical block address.

Referring to FIG. 5B, the physical block addresses 1001, 1003, 1004, and 1005 of the valid blocks are sequentially mapped to the logical block addresses starting from the lowest rank logical block address of 0.

That is, the logical block address of 0 is mapped to the physical block address 1001, the logical block address of 1 is mapped to the physical block address 1003, the logical block address of 2 is mapped to the physical block address 1004, and the logical block address of 3 is mapped to the physical block address 1005.

Thereafter, the physical block addresses 1000 and 1002 of the bad blocks are sequentially mapped to the logical block addresses, starting from the highest rank logical block address of 10.

That is, the logical block address of 10 is mapped to the physical block address of 1000, and the logical block address of 9 is mapped to the physical block address of 1002.

Then, remaining logical block addresses are mapped to the physical block addresses of the free blocks, starting from the lowest rank logical block address among the remaining logical block addresses.

That is, the logical block address of 4 is mapped to the physical block address 1006, the logical block address of 5 is mapped to the physical block address 1007, the logical block address of 6 is mapped to the physical block address 1008, the logical block address of 7 is mapped to the physical block address 1009, and the logical block address of 8 is mapped to the physical block address 1010.

As described above, the control unit 120 generates the address table of the first memory unit 130, and loads the generated address table to the second memory unit 140.

Thereafter, a data read command is input through the interface unit or an application, a logical block address corresponding to the data read command is checked and the logical block address checked is replaced with a corresponding physical block address to request an access to the first memory unit 130.

Referring to FIG. 5B, the control unit 120, if the logical block address checked is 0, replaces the logical block address with a physical block address of 1001 that corresponds to the logical block address 0 to request an access to data. If the logical block address checked is 1, the control unit 120 replaces the logical block address with a physical block address of 1003 that corresponds to the logical block address 1 to request an access to data.

Since the control unit 120 attempts a read only with respect to a valid block, the physical block addresses 1000 and 1002 which are the bad blocks are not requested with a read.

As described above, an address table of the flash memory, which is a non-volatile memory, is stored in another memory, thereby removing constraints that are related to storing an address table at a power failure, simplifying the functionalities of the flash memory, and enhancing the spatial efficiency.

In addition, the file access speed of a flash memory, which is a non-volatile memory, is increased.

In addition, a predetermined partition of the flash memory is used as a read-only area.

Although a few embodiments of the present disclosure have been shown and described, it would be appreciated by those skilled in the art that changes may be made in these embodiments without departing from the principles and spirit of the disclosure, the scope of which is defined in the claims and their equivalents.

## Claims

1. 1 A file system comprising:
a first memory unit which is non-volatile and has a plurality of blocks;
a control unit configured to select one of the plurality of blocks of the first memory unit, determine whether the selected block is a valid block, control a data write with respect to the selected block if the selected block is a valid block, divide the plurality of blocks into valid blocks and bad blocks by checking the plurality of blocks of the first memory unit, generate an address table by mapping the valid blocks and the bad blocks to addresses and control a loading of the address table generated; and
a second memory unit which is volatile and stores the address table for the plurality of blocks of the first memory unit.

2. The file system of claim 1, wherein the control unit performs a checking on a predetermined partition of the first memory unit.

3. The file system of claim 1, wherein the predetermined partition is an area having a read data.

4. The file system of claim 1, further comprising an interface unit configured to receive a data used to perform a write on the first memory and indicate a data that corresponds to a command of the control unit.

5. The file system of claim 1, wherein the control unit generates the address table by sequentially mapping the valid blocks to addresses starting from a lowest rank address among the addresses, and sequentially mapping the bad blocks to addresses starting from a highest rank address among the addresses.

6. The file system of claim 1, wherein if the selected block is a bad block, the control unit selects another block and determines whether the other block is a valid block to perform a data write.

7. The file system of claim 1, wherein the control unit performs a read operation only on the valid block based on the address table stored in the second memory unit.

8. The file system of claim 1, wherein the control unit regenerates the address table when the first memory unit is booted.

9. The file system of claim 1, wherein the first memory unit comprises a readable memory.

10. A method of controlling a file system, the method comprising:
checking a plurality of blocks of a first memory unit, which is non volatile, to divide the plurality of blocks into valid blocks and bad blocks;
generating an address table by mapping the divided valid blocks and bad blocks to addresses;
loading the generated address table to a second memory unit that is volatile;
storing the generated address table in the second memory unit; and
performing a read operation only on the valid block based on the address table that is stored in the second memory unit, if a read command for the first memory unit is input.

11. The method of claim 10, wherein the generating of the address table comprises:
sequentially mapping logical block addresses to physical block addresses of the valid blocks, starting from a lowest rank logical block address among the logical block addresses; and
sequentially mapping logical block addresses to physical block addresses of the bad blocks, starting from a highest rank logical block address among the logical block addresses, thereby generating the address table.

12. The method of claim 10, further comprising:
selecting one of the plurality of blocks of the first memory unit if a write command is input through an interface unit;
determining whether the selected block is a valid block; and
performing a data write operation on the selected block if the selected block is a valid block.

13. The method of claim 12, further comprising:
selecting another block of the plurality of blocks if the selected block is a bad block and determining whether the other block is a valid block; and
performing a data write.

14. The method of claim 10, wherein the checking of the plurality of blocks of the first memory unit to divide the plurality of blocks into the valid blocks and the bad blocks comprises:
marking a predetermined partition of the first memory unit; and
performing a checking on blocks within the predetermined partition to divide the checked blocks into bad blocks and valid blocks.
